(19) Europäisches Patentamt
European Patent Office
Office européen des brevets

(11) **EP 3 559 989 B1**

(12) **EUROPÄISCHE PATENTSCHRIFT**

(45) Veröffentlichungstag und Bekanntmachung des Hinweises auf die Patenterteilung:
**23.08.2023   Patentblatt 2023/34**

(21) Anmeldenummer: **17829181.1**

(22) Anmeldetag: **19.12.2017**

(51) Internationale Patentklassifikation (IPC):
**H01L 23/373** (2006.01)    **H05K 1/05** (2006.01)
**H05K 1/02** (2006.01)    **H05K 3/00** (2006.01)
**H01L 23/31** (2006.01)

(52) Gemeinsame Patentklassifikation (CPC):
**H05K 3/0061; H01L 23/3735; H05K 1/053;**
H01L 23/3121; H05K 1/0203

(86) Internationale Anmeldenummer:
**PCT/EP2017/083434**

(87) Internationale Veröffentlichungsnummer:
**WO 2018/114880 (28.06.2018 Gazette 2018/26)**

(54) **TRÄGERSUBSTRAT FÜR ELEKTRISCHE BAUTEILE UND VERFAHREN ZUR HERSTELLUNG EINES TRÄGERSUBSTRATS**

CARRIER SUBSTRATE FOR ELECTRIC COMPONENTS AND MANUFACTURING METHOD FOR CARRIER SUBSTRATE

SUBSTRAT PORTEUR POUR COMPOSANTS ÉLECTRIQUES ET MÉTHODE DE FABRICATION POUR SUBSTRAT PORTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.12.2016   DE 102016125348**

(43) Veröffentlichungstag der Anmeldung:
**30.10.2019   Patentblatt 2019/44**

(73) Patentinhaber: **Rogers Germany GmbH**
**92676 Eschenbach (DE)**

(72) Erfinder:
• **MEYER, Andreas**
**93173 Wenzenbach (DE)**
• **GIL, Vitalij**
**91217 Hersbruck (DE)**

• **MÜLLER, László**
**91207 Lauf a. d. Pegnitz (DE)**
• **HERRMANN, Rainer**
**95485 Warmensteinach (DE)**
• **BRITTING, Stefan**
**91220 Schnaittach (DE)**

(74) Vertreter: **Müller Schupfner & Partner**
**Patent- und Rechtsanwaltspartnerschaft mbB**
**Bavariaring 11**
**80336 München (DE)**

(56) Entgegenhaltungen:
EP-A1- 2 892 074    WO-A1-2016/121660
CN-U- 202 652 683    JP-A- 2007 281 498
US-A1- 2002 001 177    US-A1- 2005 122 018
US-A1- 2010 065 962    US-A1- 2016 081 178

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung betrifft ein Trägersubstrat für elektrische, insbesondere elektronische Bauteile und ein Verfahren zur Herstellung eines Trägersubstrats.

Trägersubstrate sind beispielsweise als Leiterplatten oder Platinen aus der DE 10 2004 033 933 A1 bekannt. Typischerweise werden auf einer Bauteilseite des Trägersubstrats elektrische Bauteile und Leiterbahnen angeordnet, wobei die elektrischen Bauteile und die Leiterbahnen zu elektrischen Schaltkreisen zusammenschaltbar sind. Für Spezialanwendungen haben sich solche Trägersubstrate als besonders vorteilhaft erwiesen, die zur elektrischen Isolation der einzelnen elektrischen Bauteile und Leiterbahnen eine Isolationsschicht mit hoher elektrischer Isolationsfestigkeit aufweisen, wie z.B. eine aus Keramik gefertigte Primärschicht.

Im Betrieb dieser Trägersubstrate werden die elektrischen Bauteile typischerweise derart beansprucht, dass sie erhitzen und sich auf der Bauteilseite lokale Wärmequellen ausbilden. Um durch das Erhitzen veranlasste Schädigungen an den elektrischen Bauteilen oder dem Trägersubstrat zu vermeiden, kennt der Stand der Technik daher z.B. aus der DE 10 2009 022 877 A1 Wärmesenken oder Kühlstrukturen, die in der Regel an einer der Bauteilseite gegenüberliegenden Kühlseite, die beispielsweise als an die Primärschicht angrenzende Kupferschicht bzw. Kupferbasis ausgebildet ist, angelötet sind. Um eine ausreichende Wärmekapazität durch die Wärmesenke oder durch die Kühlstruktur bereitzustellen, müssen die Wärmesenken und/oder die Kühlstrukturen entsprechend groß dimensioniert werden, wodurch sich eine bauraumfüllende Ausgestaltung für das Trägersubstrat in nachteilhafter Weise nicht vermeiden lässt.

Zudem stellen bestimmte elektrische Bauelemente bzw. deren Leistungsdichte erhöhte Anforderungen an die Kühlperformance des Trägersubstrats. Ferner können beim Einsatz der elektrischen Bauteile parasitäre Induktivitäten am Trägersubstrat auftreten, die sich nachteilig auf den Betrieb des Trägersubstrats auswirken. Schließlich stellt bei solchen Trägersubstarten die elektromagnetische Verträglichkeit hohe Anforderungen an die verwendeten Leiterstrukturen bzw. die metallischen Strukturen im Allgemeinen.

Aus der EP 2 892 074 A1 ist ein Leistungsmodulsubstrat bekannt, bei dem eine Vielzahl von Schaltungsschichtmetallplatten aus Kupfer in einem geschichteten Zustand unter Zwischenfügen eines ersten Keramiksubstrats gebondet sind. Ferner ist ein zweites Keramiksubstrat vorgesehen, wobei zwischen dem ersten Keramiksubstrat und dem zweiten Keramiksubstrat eine Metallschicht angeordnet ist. An dem zweiten Keramiksubstrat ist weiterhin eine Wärmeabstrahlungsschicht aus Aluminium vorgesehen.

Aus der US 2010 065 962 A1 ist ein weiteres Leistungsmodul bekannt, das eine geschichteten Aufbau aus mehreren Metallschichten und Keramikschichten vorsieht.

Aus der WO 2016 121 660 A1 ist ein Metall-Keramik-Substrat bekannt, das zwischen zwei Keramiklagen eine metallische Zwischenschicht aufweist, die dicker ist als die Keramiklagen.

Es ist somit eine Aufgabe der vorliegenden Erfindung, Trägersubstrate mit einer beispielsweise aus Keramik gefertigten Primärschicht, insbesondere in Hinblick auf Größe, Gewicht, Kühlperformance, elektromagnetische Verträglichkeit und parasitäre Induktivitäten, zu verbessern.

Diese Aufgabe wird gelöst durch ein Trägersubstrat für elektrische Bauteile gemäß Anspruch 1 und ein Verfahren gemäß Anspruch 14. Weitere Vorteile und Merkmale der Erfindung ergeben sich aus den Unteransprüchen sowie der Beschreibung und den beigefügten Figuren.

Erfindungsgemäß ist ein Trägersubstrat für elektrische Bauteile, insbesondere elektronische Bauteile, vorgesehen, wobei das Trägersubstrat eine Bauteilseite und eine der Bauteilseite gegenüberliegende Kühlseite mit einer Kühlstruktur aufweist, wobei das Trägersubstrat zur elektrischen Isolation eine der Bauteilseite zugewandte und insbesondere aus Keramik, z.B. $Al_2O_3$, $Si_3N_4$, AIN oder HPSX-Keramik (, d. h. einer Keramik mit einer $Al_2O_3$- Matrix, die einen x-prozentigen Anteil an $ZrO_2$ umfasst, beispielsweise $Al_2O_3$ mit 9% $ZrO_2$ = HPS9 oder $Al_2O_3$ mit 25% $ZrO_2$ = HPS25), gefertigte Primärschicht und zur Versteifung des Trägersubstrats eine der Kühlseite zugewandte Sekundärschicht umfasst, wobei zur Wärmeübertragung von der Bauteilseite zur Kühlseite zwischen der Primärschicht und der Sekundärschicht eine metallische Zwischenschicht angeordnet ist, wobei die metallische Zwischenschicht dicker als die Primärschicht und die Sekundärschicht ist.

Die Primärschicht weist eine Isolationsschicht mit hoher elektrischer Isolationsfestigkeit auf, bevorzugt von mehr als 5kV/mm, besonders bevorzugt von mehr als 10, 20 oder sogar mehr als 30kV/mm und/oder mit hoher Wärmeleitfähigkeit auf, bevorzugt von mehr als 10W/mK, besonders bevorzugt von mehr als 20W/mK oder sogar mehr als 60W/mK, wie z. B. technische Keramiken oder mit wärmeleitenden Materialen gefüllte organische Isolationswerkstoffe. Die Dicke der Primärschicht und/oder der Sekundärschicht ist vorzugweise derart ausgestaltet bzw. ausgewählt, dass sie den Anforderungen an die Spannungsfestigkeit bzw. an die Durchschlagfeldstärke gerecht wird. Es hat sich dabei herausgestellt, dass dies bei der Mehrzahl der Anwendungen eine Dicke der Primärschicht und/oder der Sekundärschicht von 0,1 - 0,4 mm aus den bereits genannten keramischen Materialien erfordert. Im Falle von solchen Trägersubstraten, die z.B. bei der Hochspannungsgleichstromübertragung eine Spannungsfestigkeiten von 10 - 15 kV mit neuartigen auf SiC Basis arbeitender Halbleiterbauelemente fordern, sind hingegen Schichtdicken der Primärschicht und/oder der Sekundärschicht von bis zu 2mm und mehr erforderlich.

Gegenüber dem Stand der Technik wird das Trägersubstrat in einer Sandwichbauweise bereitgestellt, bei der die Primärschicht und die Sekundärschicht durch die metallische Zwischenschicht beabstandet sind. Durch die Zwischenschicht kann sich der von der lokalen Wärmequelle ausgehende Wärmestrom in Richtung der Sekundärschicht bzw. der Kühlseite besser aufspreizen und für eine großflächigere Wärmeverteilung an der Kühlseite, die die kritische Wärmeübergangsfläche für den Abtransport der Wärme bildet, sorgen. Dadurch lässt sich der statische Wärmewiderstand ($R_{TH}$) des gesamten Trägersubstrats, d. h. der thermische Widerstand, der sich im stationären Betrieb des Trägersubstrats einstellt, verbessern. Beispielsweise lässt sich auf diese Weise der statische thermische Wärmewiderstand um bis zu 30 % verbessern. Infolgedessen kann auf eine überdimensionierte Kühlstruktur, die andernfalls eine 3 mm bis 5 mm dicke Bodenplatte umfasst, auf der Kühlerseite des Trägersubstrats verzichtet werden. Dies führt nicht nur in vorteilhafter Weise dazu, dass auf Material verzichtet werden kann und damit die Herstellungskosten gesenkt werden können, sondern es erlaubt auch, das Trägersubstrat symmetrisch - insbesondere in Hinblick auf eine Metallbeschichtung auf der Bauteilseite sowie auf der Kühlseite - auszugestalten, wodurch im Betrieb thermisch induzierten mechanischen Spannungen bzw. einer mechanischen Hebelwirkung entgegengewirkt werden kann. Solche mechanischen Spannungen können andernfalls - beispielsweise in Form eines Bi-Metall-Effekts - und insbesondere bei Verwendung dicker Kühlstrukturen, zum Verbiegen des Trägersubstrats führen.

Darüber hinaus bewirkt die Zwischenschicht, dass der transiente bzw. dynamische Wärmewiderstand ($Z_{TH}$) ausreichend dimensioniert ist, da bei Einschaltvorgängen oder Leistungsspitzen die Zwischenschicht die Wärme kurzfristig aufnehmen bzw. speichern kann. Zu berücksichtigen ist hierbei, dass das Trägersubstrat bevorzugt in Hinblick auf seinen statischen thermischen Wärmewiderstand ausgelegt wird. Hierbei setzt der statische thermische Wärmewiderstand bevorzugt nach ca. 20 bis 30 s ein und ist vorteilhaft am Bauteil zu messen. Für den Vergleich des dynamischen Verhaltens verschiedener Systeme ist es auch vorstellbar, den thermischen Widerstand 300 ms nach Beginn des Einschaltvorgangs zu messen.

Weiterhin erweist es sich als vorteilhaft, dass die vergleichsweise dicke Zwischenschicht zur Versteifung bzw. Stabilisierung des gesamten Trägersubstrats beiträgt. Dabei erweist sich das Trägersubstrat, insbesondere sowohl gegenüber Eigenspannungen als auch gegenüber äußeren Kräften, wie sie z. B. durch die Kühlflüssigkeit auf das Trägersubstrat wirken, als ausreichend steif. Weiterhin lässt sich die Schichtdicke der Keramikschichten in vorteilhafter Weise reduzieren.

Gemäß einer bevorzugen Ausführungsform der vorliegenden Erfindung ist vorgesehen, dass die Zwischenschicht zwischen 1,1- und 10- mal, bevorzugt zwischen 1,2- und 5-mal, besonders bevorzugt zwischen 1,3- und 3 mal oder sogar im Wesentlichen 1 ,5-mal so dick ist wie die Primärschicht und/oder die Sekundärschicht. Die Zwischenschicht kann aber auch andere Dicken aufweisen. Insbesondere ist die Zwischenschicht zwischen 1 mm und 10 mm, bevorzugt zwischen 1 mm und 5 mm, besonders bevorzugt zwischen 1,5 mm und 5 mm oder sogar im Wesentlichen 1,5 mm dick. Es hat sich in überraschender Weise gezeigt, dass sich der statische thermische Widerstand außerhalb dieser Wertebereiche, d. h. sowohl mit zunehmender als auch mit abnehmender Zwischenschichtdicke, insbesondere bezogen auf die Dicken der Primärschicht und/oder der Sekundärschicht, verschlechtert. Entsprechend ist es von Vorteil zur Optimierung der Kühlperformance, die Zwischenschichtdicke entsprechend anzupassen.

Gemäß einer bevorzugen Ausführungsform der vorliegenden Erfindung ist vorgesehen, dass die Zwischenschicht zwischen 2,5 - und 100 - mal, bevorzugt zwischen 3,5- und 50-mal, besonders bevorzugt zwischen 10 und 25 mal oder sogar im Wesentlichen 20-mal so dick ist wie die Primärschicht und/oder die Sekundärschicht. Die Zwischenschicht kann aber auch andere Dicken aufweisen. Insbesondere ist die Zwischenschicht zwischen 1 mm und 10 mm, bevorzugt zwischen 1 mm und 5 mm, besonders bevorzugt zwischen 1,5 mm und 5 mm oder sogar im Wesentlichen 3 mm dick. Derart dicke Zwischenschichten ermöglichen mit Vorteil eine optimale Wärmespreizung in der Zwischenschicht, wodurch sich in vorteilhafter Weise die transportierte Wärme möglichst gleichmäßig verteilt bevor sie über die Kühlstruktur abgeleitet wird.

Gemäß einer weiteren Ausführungsform der vorliegenden Erfindung ist es vorgesehen, dass die Zwischenschicht dicker als 1 mm ist, bevorzugt dicker als 1,4 mm und besonders bevorzugt dicker als 1,9 mm ist. Diese vergleichsweise dicken Zwischenschichten erweisen sich insbesondere für eine Mehrheit an verschiedenen Trägersubstrattypen als vorteilhaft für die Wärmspreizung. Dabei ist es mit Vorteil möglich, die Zwischenschichten derart dick zu gestalten, dass die Kühlstruktur an der Kühlseite in ihrer Größe wiederum kleiner dimensioniert werden kann. Vorstellbar ist sogar, dass trotz der Vergrößerung der Zwischenschichtdicke, die Kühlstruktur derart kleiner dimensioniert werden kann, das sich im Gesamten eine Gesamtdicke des Trägersubstrats verkleinert lässt.

Zweckmäßig ist es vorgesehen, dass die Kühlstruktur einen Basiskörperbereich und einen Stegbereich aufweist, wobei ein Verhältnis (SD/BD) zwischen einer Stegbereichsdicke zu einer Basiskörperdicke einen Wert zwischen 1,2 bis 6, bevorzugt zwischen 1,4 und 3 und besonders bevorzugt zwischen 1,6 und 2,5 annimmt. Bei vergleichbarer Kühlleistung hat es sich mit Vorteil gezeigt, dass sich der Stegbereich, d. h. beispielsweise die Finnen eines Kühlkörpers, signifikant kürzer dimensionieren lassen. Folge ist eine kompaktere Bauweise des Trägersubstrats und optimierte Strömungsverhältnisse. Als besonders vorteilhaft hat es sich erwiesen, das Verhältnis zwischen 1,6 und 2,5 auszuwählen, da sich dadurch sowohl eine verbesserte Kühlwirkung erzielen lässt, als auch ein vergleichsweise kompakte Bauweise des Trägersubstrats. Der Stegbereich wird vorzugsweise durch senkrecht vom Basiskörperbereich abstehende Stege bzw. Finnen gebildet, während der Basiskörperbereich insbesondere einen massiven bzw. geschlossenen Bereich bildet. Denkbar ist auch, dass die Stege gegenüber einer senkrechten Ausrichtung zum Basiskörperbereich geneigt sind. Insbesondere werden die Stegbereichsdicke und die Basiskörperdicke in einer senkrecht zur Haupterstreckungsebene verlaufenden Richtung bemessen.

Vorzugsweise ist eine Kühlstrukturdicke, insbesondere eine effektive Kühlstrukturdicke, 0,03 bis 1 mal, bevorzugt 0,1 bis 0,5 und besonders bevorzugt 0,15 bis 0,3 so groß ist wie die metallische Zwischenschicht. Überraschender Weise hat sich gezeigt, dass sich so dünne Kühlstrukturdicken realisieren lassen. Neben der Reduktion der Gesamtdicke, ist es in vorteilhafter Weise möglich, die Kühlstrukturdicken so zu dimensionieren, dass sie eine Dicke, insbesondere eine effektive Kühlstrukturdicke, aufweisen, die vergleichbar ist mit der Dicke einer Metallisierung auf der gegenüberliegenden Bauteilseite. Bei der effektiven Kühlstrukturdicke wird mitberücksichtigt, dass die Kühlstruktur nicht eben ist, sondern strukturiert, d. h. es wird ein Dickenäquivalent der strukturierten Kühlstruktur zu einem nicht-strukturierten Kühlkörper angenommen.

Grundsätzlich ist die insbesondere aus Keramik gefertigte Primärschicht flach und plattenförmig ausgestaltet und erstreckt sich vorzugsweise über die gesamte Bauteilseite des Trägersubstrats, wobei die Sekundärschicht insbesondere parallel zur Primärschicht ausgerichtet ist. Auf der Bauteilseite, konkreter auf der von der Zwischenschicht abgewandten Seite der Primärschicht, sind insbesondere metallische Anschlusselemente und Leiterbahnen angeordnet, die vorzugsweise zur Ansteuerung von an den Anschlusselementen angebrachten elektrischen Bauteilen vorgesehen sind, die mit den metallischen Anschlusselementen elektrisch leitend verbunden sind. Weiterhin ist es nach einer Ausführungsform der Erfindung vorgesehen, dass die Kühlstruktur an der Kühlseite unmittelbar an die Sekundärschicht anschließt, d. h. zwischen der Kühlstruktur und der Sekundärschicht ist kein Lötmetall o.ä. angeordnet mit Ausnahme der Lotmetalle, die eine direkte Verbindung des Kühlers mit der Sekundärschicht ermöglichen, beispielsweise durch einen Aktivlötvorgang oder einen DCB Prozess. Ferner ist ein sich parallel zur Primärschicht durchgehend erstreckender Teil der Kühlstruktur, der sich unmittelbar an die Sekundärschicht anschließt, dünner als die metallische Zwischenschicht. Als Schichtdicke ist die senkrecht zur Haupterstreckungsebene der Primärschicht verlaufende Ausdehnung der jeweiligen Schicht, d. h. der Zwischenschicht, der Primärschicht und der Sekundärschicht, zu verstehen, wobei die Primärschicht, die Zwischenschicht und die Sekundärschicht insbesondere entlang der senkrecht zur Haupterstreckungsebene der Primärschicht verlaufenden Richtung übereinander gestapelt bzw. angeordnet sind.

Ferner ist es vorstellbar, dass die Zwischenschicht mehrlagig ausgestaltet ist. In diesem Fall kann das Trägersubstrat durch das Aneinanderfügen einer mindestens dreilagigen oberen Mehrlagenschicht, bestehend aus Leiterbahn (ggf. mit Bauelementen bestückt), Primärschicht und erster Lage der Zwischenschicht und einer mindestens dreilagigen unteren Mehrlagenschicht, bestehend aus zweiter Lage der Zwischenschicht, Sekundärschicht und Kühlstruktur, hergestellt werden. Obere und untere Mehrlagenschicht können dabei mittels eines DCB-Verfahrens, eines DAB Prozesses, Diffusionsschweißen, einer Lötverbindung oder durch einen Sinternprozess, wie z.B. Silbersintern, oder einer weiteren Schicht, wie z.B. einer wärmeleitenden, klebenden Isolationsschicht, wie z.B. einer Epoxyschicht oder einer Polyamidschicht, miteinander verbunden werden.

Darüber hinaus ist es weiterhin denkbar, dass das Trägersubstrat in der Sandwichbauweise eine oder mehrere weitere Primärschichten zur elektrischen Isolation, eine oder mehrere weitere Sekundärschichten zur Stabilisierung des Trägersubstrats und/oder eine mehrere weitere Zwischenelemente zum Wärmetransport von der Bauteilseite zur Kühlseite aufweist. Bei dem elektrischen Bauteil handelt es sich beispielsweise um ein Halbleiterbauelement aus Si, SiC oder GaN.

Weitere Vorteile und Merkmale ergeben sich aus der nachfolgenden Beschreibung bevorzugter Ausführungsformen des erfindungsgemäßen Gegenstands. Einzelne Merkmale der einzelnen Ausführungsform können dabei im Rahmen der Erfindung miteinander kombiniert werden.

Um für eine ausreichende Wärmekapazität der Zwischenschicht zu sorgen, ist es ferner vorgesehen, dass die Schichtdicke der Zwischenschicht größer, vorzugsweise mehr als doppelt so groß, bevorzugt mehr als dreimal so groß und besonders bevorzugt mehr als fünfmal so groß ist wie die aufaddierte Schichtdicke der Primärschicht und der Sekundärschicht. Vorstellbar ist auch, dass das Verhältnis zwischen der Schichtdicke der Zwischenschicht zur Gesamtdicke des Trägersubstrats einen Wert zwischen 0,2 und 0,8, bevorzugt einen Wert zwischen 0,3 und 0,7 und besonders bevorzugt einen Wert zwischen 0,4 und 0,6 annimmt. Dabei bemisst sich die Gesamtdicke des Trägersubstrats in einer senkrecht zur Primärschicht verlaufenden Richtung von der Leiterbahnen auf der Bauteilseite bis zum Abschluss der Kühlerstruktur auf der Kühlseite des Trägersubstrats. In einer besonders kompakten Ausführungsform ist die Gesamtdicke des Trägersubstrats weniger als 8 mm, vorzugsweise kleiner als 6 mm und besonders bevorzugt im Wesentlichen 4 mm.

Vorzugsweise ist es vorgesehen, dass die Leiterbahnen, die metallischen Anschlusselemente, die Zwischenschicht und/oder die Kühlstruktur aus einem Aluminium, Molybdän, Wolfram, CuMo, CuW, Invar, Kovar und/oder Silber umfassenden Material gefertigt sind. Besonders bevorzugt sind die Leiterbahnen, die metallischen Anschlusselemente, die Zwischenschicht und/oder die Kühlstruktur aus einem Kupfer umfassenden Material gefertigt. Vorstellbar ist auch, dass die Leiterbahnen, die metallischen Anschlusselemente, die Zwischenschicht und/oder die Kühlstruktur aus Verbundwerkstoffen wie z.B. einer Laminierung der genannten Metalle oder als pulvermetallurgisch hergestellter Metall-Matrix-Verbund realisiert ist. Solche Verbundwerkstoffe können bevorzugt aus den bereits genannten Metallen gefertigt sein, die aber zum Zwecke der CTE Anpassung und einer erhöhten Steifigkeit mit Metall-Matrix Verbundwerkstoffen realisiert werden, die mit keramischen Partikeln gefüllt sind wie z.B. Al mit $Al_2O_3$ und/oder SiC und/oder $Si_3N_4$ oder auch Graphit oder Diamantpulver. Um für eine ausreichende Stabilität des Trägersubstrats zu sorgen, ist die Primärschicht und/oder die Sekundärschicht derart gestaltet, dass ein Elastizitätsmodul für die Primärschicht und/oder die Sekundärschicht größer als das Elastizitätsmodul der Leiterbahnen ist. Darüber hinaus ist es in einer vorteilhaften Ausführungsform vorgesehen, dass die Primärschicht und gegebenenfalls die Sekundärschicht aus einem Material gefertigt sind, deren elektrische Isolationsfestigkeit größer ist als 5 kV/mm, bevorzugt größer als 10 kV/mm und besonders bevorzugt größer als 20 kV ist oder deren Wärmeleitfähigkeit größer als 10 W/mK, bevorzugt größer als 20 W/mK und besonders bevorzugt größer als 60 W/mK ist.

Beispielsweise handelt es sich hierbei um technische Keramiken oder im Besonderen bei der Sekundärschicht um einen mit wärmeleitenden Materialien gefüllten organischen Isolationsstoff, wie z. B Epoxidharz oder Polyimid. Als besonders vorteilhaft zur Ausbildung der Primärschicht und/oder der Sekundärschicht oder als Füllstoff für die organischen Isolationsstoffe erweisen sich $Al_2O_3$, $Si_3N_4$, AlN, BeO, SiC oder MgO. Ebenso vorteilhaft erweisen sich die Keramiken auf $Al_2O_3$ Basis die neben typischen Sinteradditiven, zum Zwecke der Umwandlungsverstärkung, verschiedene ZrO2 Gehalte aufweisen können, wie beispielsweise $Al_2O_3$ mit 9% $ZrO_2$ - HPS9 oder $Al_2O_3$ mit 25% $ZrO_2$ - HPS25.

Gemäß einer weiteren Ausführungsform der vorliegenden Erfindung ist vorgesehen, dass die metallische Zwischenschicht einlagig ausgestaltet ist. Unter einlagig ist insbesondere zu verstehen, dass die metallische Zwischenschicht einteilig ausgestaltet ist und zumindest bereichsweise die Primärschicht und die Sekundärschicht miteinander durchgehend verbindet. Mit anderen Worten: die einlagige Zwischenschicht grenzt zur einen Seite an die Primärschicht und zur anderen Seite an die Sekundärschicht. Durch die einlagige Ausgestaltung lässt sich in vorteilhafter Weise der Aufwand bei der Herstellung des Trägersubstrats reduzieren, da auf ein Stapeln und Verbinden mehrerer Lagen zur Bildung der Zwischenschicht verzichtet werden kann.

In einer besonders vorteilhaften Ausführungsform der vorliegenden Erfindung ist vorgesehen, dass ein Primärsubstrat und ein Sekundärsubstrat zur Vermeidung eines Durchbiegens des Trägersubstrats in Hinblick auf ihre thermischen Ausdehnungen, insbesondere in Hinblick auf ihre Ausdehnungskoeffizienten, aneinander angepasst sind. Hierbei umfasst das Primärsubstrat neben der Primärschicht einen Teil der Zwischenschicht und der Leiterbahnschicht, und das Sekundärsubstrat umfasst neben der Sekundärschicht einen weiteren Teil der Zwischenschicht und die Kühlstruktur. Zwischen dem Primärsubstrat und dem Sekundärsubstrat ist das Zwischensubstrat bzw. der mittlere Teil der Zwischenschicht angeordnet. Vorzugsweise sind die Schichtdicken und/oder die Materialien des Primärsubstrats und/oder des Sekundärsubstrats derart aneinander angepasst, dass sich das Trägersubsubstrat im Bereich der Primärschicht und im Bereich der Sekundärschicht gleichermaßen ausdehnt. Folge ist, dass in vorteilhafter Weise thermischen Spannungen, die temperaturbedingt im Betrieb oder bei der Herstellung des Trägersubstrats auftreten können, entgegengewirkt werden kann und so die Wahrscheinlichkeit für einen das Trägersubstrat wölbenden Bi-Metalleffekt gemindert werden kann, ohne dabei die elektrischen Isolationseigenschaften des Trägersubstrats zu verschlechtern.

Vorzugsweise ist das Trägersubstrat hierzu thermomechanisch spiegelsymmetrisch zur Zwischenschicht ausgestaltet, d. h. die Schichtdicke und die Materialien, aus denen die Primärschicht und die Sekundärschicht gefertigt sind, entsprechen einander, insbesondere im thermomechanischen Verhalten. Alternativ ist es auch vorstellbar, dass bei gleicher Geometrie von Primärschicht und Sekundärschicht das Material der Sekundärschicht einen Ausdehnungskoeffizienten aufweist, der dem des Materials der Primärschicht, entspricht oder zumindest hinsichtlich seiner Größe so vergleichbar ist, dass eine gleichmäßige Ausdehnung der Primärschicht und der der Sekundärschicht bei der zur erwartenden Temperaturverteilung erfolgt. Denkbar ist auch, dass bei der Auswahl und Ausgestaltung der Primärschicht und der Sekundärschicht auch ein etwaiger bzw. ein zu erwartender Temperaturgradient über dem Trägersubstrat berücksichtigt wird.

Vorteilhaft grenzt eine für eine Fluidkühlung vorgesehene Kühlstruktur als Abschluss des Trägersubstrats auf der Kühlseite unmittelbar an die Sekundärschicht an, wobei die Kühlstruktur insbesondere als eine Rippen-, Nadel- und/oder Noppenstruktur ausgestaltet ist. Insbesondere ist die Kühlstruktur in das Trägersubstrat integriert. Als Fluide sind grundsätzlich Gase und Kühlflüssigkeiten vorstellbar. Durch die Verwendung einer Kühlflüssigkeit, die zum Wärmeaustausch mit der Kühlstruktur in Kontakt tritt, lässt sich die zur Kühlseite transportierte Wärme möglichst schnell und effizient vom Trägersubstrat wegführen. Dies steigert die Kühlperformance vorteilhafterweise weiter. Durch die Verwendung der metallischen Zwischenschicht ergibt sich zudem als synergetischer Effekt, dass sich eine Profiltiefe der Kühlstruktur reduzieren lässt. Beispielsweise weist die Kühlstruktur ein Aspektverhältnis auf, das kleiner als 8, bevorzugt kleiner als 3 und besonderes bevorzugt kleiner als 1 ist. Ein weiterer Vorteil von Kühlstrukturen mit kleinen Aspektverhältnissen ist deren Stabilität. Ferner ist die Kühlstruktur zum Korrosionsschutz vorzugsweise mit einer Korrosionsschutzschicht, wie z. B. insbesondere einer NiP, Ni, $SiO_2$, $Al_2O_3$, TiOx, NiAu, NiPdAu Schicht, beschichtet.

Dadurch lässt sich die realisierte Kühlperformance des Trägersubstrats möglichst lange über die Lebensdauer des Trägersubstrats aufrechterhalten, sowie die Lebensdauer des gesamten Kühlsystems bzw. dessen weiterer Komponenten.

Gemäß einer weiteren Ausführungsform der vorliegenden Erfindung ist vorgesehen, dass die Primärschicht eine Durchkontaktierung aufweist und/oder zur Bildung einer weiteren Leiterbahn die Zwischenschicht ein Kontaktelement aufweist. Dadurch lässt sich die metallische Zwischenschicht in vorteilhafter Weise als weitere Leiterbahn nutzen, über die Ströme zur Ansteuerung von einzelnen Bauteilen geleitet werden können, wodurch sich parasitäre induktive Störfelder bzw. Störeffekte zur Verbesserung des Ansteuerns der elektrischen Bauteile und die elektromagnetische Verträglichkeit, reduzieren bzw. verbessern lassen und sich ein niederinduktives Trägersubstrat bereitstellen lässt.

Um die Zwischenschicht elektrisch leitend mit den metallischen Anschlusselementen auf der Primärschicht zu verbinden, sind die Durchkontaktierungen bzw. Vias vorgesehen. Dabei sind die Durchkontaktierungen als Durchgangsbohrungen in der Primärschicht ausgestaltet, wobei die Durchgangsbohrung jeweils mit einem elektrisch leitenden Füllmaterial, insbesondere einer elektrisch leitenden Paste, gefüllt ist. Vorzugsweise sind die Durchkontaktierungen in einer senkrecht zu einer Haupterstreckungsebene der Primärschicht verlaufenden Richtung unmittelbar unterhalb von einem metallischen Anschlusselement angeordnet. Zum Ansteuern der metallischen Zwischenschicht bzw. zur Beaufschlagung mit einer Spannung ist es vorgesehen, dass die metallische Zwischenschicht ein eigenes Kontaktelement aufweist oder über eine Durchkontaktierung mit einem Kontaktelement auf der Bauteilseite, d. h. auf der Zwischenelement abgewandten Seite der Primärschicht, in elektrisch leitender Verbindung steht. Vorstellbar ist auch, dass eine Ansteuerung der elektrischen Bauteile auf der Bauteilseite nicht über eine Durchkontaktierung erfolgt, sondern durch Leiterbahnen, die die Primärschicht teilweise bzw. partiell umlaufen und dadurch einen Kontakt zwischen der Bauteilseite und der Zwischenschicht herstellen.

Erfindungsgemäß ist die Sekundärschicht aus Molybdän, Wolfram oder Verbundwerkstoffen basierend auf WCu oder MoCu gefertigt. Mit einer Sekundärschicht aus Keramik lässt sich ein besonders stabiles Trägersubstrat bereitstellen, wobei sich die aus Keramik gefertigte Sekundärschicht insbesondere zur elektrischen Isolation eignet, wenn die Zwischenschicht als weitere Leiterbahn verwendet wird. Daher erweist sich die Verwendung einer aus Keramik gefertigten Sekundärschicht als vorteilhaft, wenn ein Halbleiterelement aus SiC oder GaN als elektrische Bauteil vorgesehen ist. Zur Reduktion der Herstellungskosten lässt sich in vorteilhafter Weise aber auch eine Sekundärschicht aus Molybdän verwenden, insbesondere in solchen Fällen, in denen eine entsprechende Isolation nicht erforderlich ist von untergeordneter Bedeutung sind.

In einer weiteren Ausführungsform der vorliegenden Erfindung ist vorgesehen, dass die metallische Zwischenschicht, die Leiterbahn und/oder die Kühlstruktur zur Erhöhung der Temperaturwechselbeständigkeit auf der der Primärschicht und/oder der Sekundärschicht zugewandten Seite eingeätzte Strukturen aufweist. Dadurch entstehen auf der Oberfläche der Zwischenschicht, der Leiterbahnen und der metallische Anschlusselemente Öffnungen, d. h. "hidden dimple" - Strukturen, die auf die Primärschicht und/oder die Sekundärschicht gerichtet sind, wodurch in vorteilhafter Weise die Temperaturwechselbeständigkeit des Trägersubstrats bis um das 10-fache gesteigert werden kann. Diese Strukturen werden dabei punktförmig oder linienförmig eingeätzt. Die metallische Zwischenschicht weist vorzugsweise sowohl auf der der Primärschicht als auch auf der der Sekundärschicht zugewandten Seite eingeätzte Strukturen auf. Denkbar ist auch, dass die Zwischenschicht mindestens eine eingeätzte Durchgangsbohrung aufweist oder entlang einer Linie angeordnete punktförmige eingeätzte Strukturen aufweist, die nicht übereinanderliegend zueinander angeordnet sind.

Vorzugsweise ist es vorgesehen, dass das Trägersubstrat ein die Bauteilseite ummantelndes Gehäuseteil, insbesondere ein als Gussteil ausgestaltetes Gehäuseteil, aufweist, wobei das Gehäuseteil vorzugsweise mit der auf der Kühlseite angeordneten Kühlstruktur bündig abschließt. Das Gehäuseteil schützt in vorteilhafter Weise die elektrischen Bauteile auf der Bauteilseite vor äußeren Einflüssen. Um mit den elektrischen Bauteilen auf dem Trägersubstrat zu kommunizieren, verlaufen die Kontaktelemente vorzugsweise durch das Gehäuseteil und stehen einem Nutzer als Kontakte an der Außenseite des Gehäuseteils zur Verfügung. Das bündige Abschließen des Gehäuseteils mit der Kühlstruktur erweist sich insofern als vorteilhaft, als dass es dem Nutzer die Möglichkeit offen lässt, das Trägersubstrat auf einer Wärmesenke, insbesondere auf einem als Wärmesenke dienenden Festkörper, beispielsweise zusammen mit anderen Trägersubstraten, zu montieren oder an die Kühlstruktur ein Schalenelement bzw. ein Bauteil zur Bildung eines Fluidkanals, insbesondere eines Flüssigkeitskanals, zu koppeln.

In einer vorteilhaften Ausführungsform der vorliegenden Erfindung ist es vorgesehen, dass die Kühlstruktur eine Ausnehmung in der Metallschicht zur Bildung einer Dehnungsfuge in einem Bereich angrenzend an den Randverlauf der Sekundärschicht aufweist. Insbesondere ist es vorgesehen, dass die als Dehnungsfuge dienende Ausnehmung nicht von der Sekundärschicht überdeckt ist. Dadurch ist es in vorteilhafter Weise möglich, dass eine thermische Längsausdehnung der Kühlstruktur nicht zur Ausbildung von mechanischen Spannungen führt, indem die als Dehnungsfuge dienende Ausnehmung die Längsausdehnung der Kühlstruktur auffängt.

Ein weiterer Gegenstand der vorliegenden Erfindung ist ein Verfahren zur Herstellung eines Trägersubstrats. Sämtliche für das erfindungsgemäße Trägersubstrat beschriebenen Merkmale und deren Vorteile lassen sich sinngemäß ebenfalls auf das erfindungsgemäße Verfahren übertragen und andersrum.

Konkret schlägt das Verfahren zur Herstellung eines Trägersubstrats vor, dass die Leiterbahnschicht, die Primärschicht, die Sekundärschicht, die Zwischenschicht und die Kühlstruktur mit einer einheitlichen Verbindungsmethode, insbesondere zeitgleich in einem gemeinsamen Verfahrensschritt, gefügt bzw. gebondet werden. Insbesondere ist es vorgesehen, dass die Kühlstruktur im Rahmen der Trägersubstratherstellung an die Sekundärschicht angebunden wird. Durch das zeitgleiche Fügen bzw. Bonden der einzelnen Schichten lässt sich in vorteilhafter Weise ein Durchbiegen der einzelnen Schichten, wie es beim nachträglichen Anfügen der Kühlstruktur üblich ist, bei der Herstellung vermeiden. Als Fügeverfahren bzw. Verbindungsmethode ist ein DCB-Verfahren, ein Aktivlöten, ein Hartlöten oder ein Kleben vorstellbar.

Alternativ ist es auch vorstellbar zwei oder mehrere Teilsubtrate getrennt in einem ersten Schritt mit bereits erwähnten Fügemethoden zu fertigen, wie beispielsweise die Primärschicht mit der Leiterbahnschicht und einem Teil der metallischen Zwischensicht, sowie die Sekundärschicht mit einem Teil der metallischen Zwischenschicht und der Kühlerstruktur. Diese beiden Einzellaminate werden in einem zweiten Fügeschritt zum erfindungsgemäßen Substrat gefügt, mittels gängiger Fügeprozesse wie z.B. DCB Verfahren, Hartlöten, Weichlöten, Diffusionsschweißen oder einem Sinterprozess.

Unter einem "DCB-Verfahren" (Direct-Copper-Bond-Technology) versteht der Fachmann ein solches Verfahren, das beispielsweise zum Verbinden von Metallschichten oder -blechen (z. B. Kupferblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht) aus einer chemischen Verbindung aus dem Metall und einem reaktiven Gas, bevorzugt Sauerstoff, aufweisen. Bei diesem beispielsweise in der US 3 744 120 A oder in der DE23 19 854 C2 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:

- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1025 bis 1083°C, z. B. auf ca. 1071°C;
- Abkühlen auf Raumtemperatur.

Unter einem Aktivlot-Verfahren z. B. zum Verbinden von Metallschichten oder Metallfolien, insbesondere auch von Kupferschichten oder Kupferfolien mit Keramikmaterial ist ein Verfahren zu verstehen, welches speziell auch zum Herstellen von Metall-Keramik-Substraten verwendet wird, wird bei einer Temperatur zwischen ca.650-1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist.

Insbesondere ist es vorgesehen, dass die Kühlstruktur im Rahmen der Trägersubstratherstellung angebunden bzw. gefügt wird. Dadurch wird die Temperaturstabilität in den Schnittstellenbereichen bis in die vom Hartlöten oder vom DCB-Verfahren betroffenen Bereiche des Trägersubstrats erhöht. Folge ist, dass das Trägersubstrat auch für Bauteile aus Halbleitermaterialien, wie SiC oder GaN, die bei Temperaturen oberhalb von 200 °C betrieben werden können, genutzt werden kann bzw. in den nachgelagerten Aufbau und Verbindungsprozessen zur Modulherstellung keine Limitierung bis z.B. 400°C hinsichtlich der Prozesstemperaturen bestehen

Gemäß einer weiteren Ausführungsform der vorliegenden Erfindung wird das Trägersubstrat virtuell in ein Primärsubstrat, ein Sekundärsubstrat und vorzugsweise. in eine dazwischen befindliche virtuelle Zwischenschicht d15.2 zerlegt. Das Primärsubstrat wird aus den Schichten d12, d10 und d15.1 und das Sekundärsubstrat aus den Schichten d15.3, d20 und d30 gebildet. Bei der Dimensionierung wird eine thermomechanische Symmetrie zwischen dem Primärsubstrat und dem Sekundärsubstrat angestrebt, d.h. der thermische Ausdehnungskoeffizient (CTE) beider Substrate soll vorzugsweise gleich oder zumindest ähnlich sein, beispielsweise innerhalb einer Toleranz von +/- 20 % oder bevorzugt +/- 10 %, besonders bevorzugt +/- 5% übereinstimmen. Das ist notwendig, um mögliche thermomechanische Spannungen und die daraus resultierenden Durchbiegungseffekte zu reduzieren. Der resultierende Wärmeausdehnungskoeffizient CTE' eines geschichteten Verbundmaterials wird näherungsweise wie folgt errechnet:

$$CTE' = \frac{\sum_{i=1}^{n} CTEi\, Ei\, di}{\sum_{i=1}^{n} Ei\, di}$$

Unter näherungsweise versteht der Fachmann hierbei insbesondere, dass der bestimmte Wärmeausdehnungskoeffizienten bis zu 2 bis 4 % von dem tatsächlichen Wärmeausdehnungskoeffizienten abweicht.

Hierbei wird angenommen, dass sich das jeweilige Teilsubstrat nicht oder nur unwesentlich biegt. Neben dem jeweiligen Ausdehnungskoeffizienten $CTE_i$ geht hier auch jeweils das Elastizitätsmodul $E_i$ sowie die Schichtdicke $d_i$ ein. Die mögliche Biegung wird vermieden, indem die beidseitigen Metallisierungen in thermomechanischer Hinsicht gleich bzw. ähnlich sind, das bedeutet, dass z.B. bei vollflächigen Metallisierungen beide Metallschichten gleich oder zumindest ähnlich dick sind. Daraus ergibt sich, das vorzugsweise d15.1 = d12 und d15.3 = d30E ist, wobei d30E eine effektive Schichtdicke der Kühlerschicht ist, bei der eine mögliche Strukturierung der Kühlstruktur berücksichtigt wird.

Für das Primärsubstrat gilt damit:

$$CTE10' = \frac{CTE12\, E12\, d12 + CTE10\, E10\, d10 + CTE15.1\, E15.1\, d15.1}{E12\, d12 + E10\, d10 + E15.1\, d15.1}$$

und das Sekundärsubstrat gilt:

$$CTE20' = \frac{CTE15.3\, E15.3\, d15.3 + CTE20\, E20\, d20 + CTE30\, E30\, d30E}{E15.3\, d15.3 + E20\, d20 + E30\, d30E}$$

wobei d30E die thermomechanisch effektiv wirkende Dicke der Kühlstruktur 30 ist. Die Dicke d30E ist von der Strukturierung der Kühlstruktur 30 abhängig, für die folgendes gilt:

$$d30.1 \leq d30E \leq d30$$

Ist es bei der Dimensionierung der einzelnen Komponenten bzw. Schichten des Trägersubstrates nicht sinnvoll möglich, eine vollständige thermomechanische Symmetrie ( CTE10' = CTE20' ) einzustellen, ist eine temperaturabhängige Biegung zu erwarten.. Der beschriebene Ansatz dient primär der Optimierung des Schichtaufbaus in thermomechanischer Hinsicht mit dem Ziel möglichst ebene Trägersubstrate zu realisieren.

Die Wahl der Zwischenschicht 15 und damit die Dicke der resultierenden virtuellen Zwischenschicht d15.2 ist von der notwendigen thermischen Masse abhängig, die das zeitlichen Verhalten des Trägersubstrates 1 maßgeblich definiert. Die für die thermische Masse relevanten Schichten sind die Leiterbahnen d12, die Zwischenschicht d15 sowie die Basisdicke d30.1 der Kühlstruktur 30. Die Dicke der thermischen Pufferlagen ist somit mit *dCu_th* = d12 + d15 + d30.1 definiert. Die Dicke der thermischen Pufferlagen *dCu_thst* zwischen 1 und 10 mm, bevorzugt zwischen 1,1 und 5 mm, besonders bevorzugt zwischen 1,2 und 3 mm.

Die optimale Biegung h ist in den meisten Anwendungsfällen null. Der Betrag der Biegung h ist kleiner als 200 $\mu$m, bevorzugt kleiner als 100 $\mu$m und besonders bevorzugt kleiner als 50 $\mu$m.

Alle oben gemachten Angaben sind näherungsweise zu verstehen, da die jeweilige Strukturierung insbesondere der Leiterbahnen d12 sowie der Kühlstruktur 30 sowie abweichend wirkende Randeffekte an den Kanten der Komponenten nicht pauschal Berücksichtigung finden können. Die o.g. Modelle basieren auf einem rein elastischen Verhalten der Materialien. Der Einfluss der plastischen Deformation spielt hier eine untergeordnete Rolle.

Gemäß einer weiteren Ausführungsform der vorliegenden Erfindung ist es vorgesehen, dass bei der Bestimmung des Wärmeausdehnungskoeffizient CTE ein Querkontraktionsverhalten mitberücksichtigt wird. Insbesondere ist es vorgesehen, dass der Wärmeausdehnungskoeffizient in Abhängigkeit einer Querkontraktionszahl v bzw. vi bestimmt wird, bevorzugt gemäß

$$CTE' = \frac{\sum_{i=1}^{n} CTEi\, \dfrac{E}{(1 - vi)}\, di}{\sum_{i=1}^{n} \dfrac{Ei}{(1 - vi)}\, di}$$

Damit lässt sich der Wärmeausdehnungskoeffizient noch genauer bestimmen.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Es zeigt:

Fig.1: ein Trägersubstrat für elektrische Bauteile gemäß einer ersten beispielhaften Ausführungsform der vorliegenden Erfindung .

Fig. 2 ein Trägersubstrat für elektrische Bauteile gemäß einer zweiten beispielhaften Ausführungsform der vorliegenden Erfindung

Fig. 3 ein Trägersubstrat für elektrische Bauteile gemäß einer dritten beispielhaften Ausführungsform der vorliegenden Erfindung

Fig. 4 ein Trägersubstrat für elektrische Bauteile gemäß einer vierten beispielhaften Ausführungsform der vorliegende Erfindung

Fig. 5 das Trägersubstrat aus Figur 4 in einem gebogenen Zustand

Fig. 6 eine Kühlstruktur für ein Trägersubstrat gemäß einer fünften Ausführungsform der vorliegenden Erfindung.

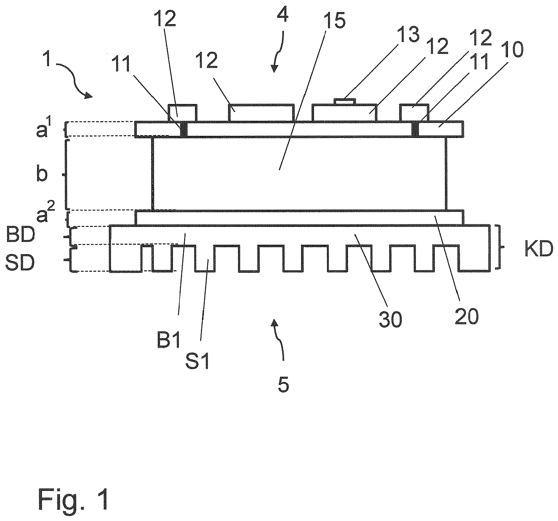

In **Figur 1** ist schematisch ein Trägersubstrat 1 für elektrische Bauteile 13 gemäß einer ersten beispielhaften Ausführungsform der vorliegenden Erfindung in einer Schnittansicht dargestellt. Hierbei handelt es sich vorzugsweise um ein für Spezialanwendungen vorteilhaftes keramikhaltiges Trägersubsubstrat 1. Insbesondere weist das Trägersubstrat 1 eine Bauteilseite 4 auf, auf der voneinander elektrisch isolierte metallische Leiterbahnen 12, beispielsweise aus Kupfer oder Aluminium, für elektrische Bauteile 13 bzw. Module vorgesehen sind. Durch das Anbinden von elektrischen Bauteilen 13 an den metallischen Leiterbahnen 12 und das Verbinden der Leiterbahnen 12 lassen sich elektrische Schaltkreise realisieren, mit denen die elektrischen Bauteile 13 ansteuerbar sind. Um einer im Betrieb auftretenden und von den elektrischen Bauteilen 13 ausgehenden Wärmeentwicklung, insbesondere eine in Bereichen mit elektrischen Bauteilen 13 lokal auftretenden Wärmeentwicklung, entgegenzuwirken, ist auf einer der Bauteilseite 4 gegenüberliegenden Kühlseite 5 eine in das Trägersubstrat 1 integrierte Kühlstruktur 30 vorgesehen.

Insbesondere handelt es sich bei der Kühlstruktur 30 um eine metallische Nadel- bzw. Pin-Struktur, entlang der im Betrieb ein Fluid, vorzugsweise eine Kühlflüssigkeit, vorbeiströmt, wodurch in vorteilhafter Weise die von der Kühlstruktur 30 an das Fluid abgegebene Wärme kontinuierlich abtransportiert werden kann.

Um auf der Bauteilseite 4 für eine elektrische Isolation zwischen den einzelnen Leiterbahnen 12 zu sorgen, ist an der Bauteilseite 4 eine aus Keramik gefertigte Primärschicht 10 vorgesehen. Hierbei ist die Primärschicht 10 plattenförmig ausgestaltet. Zur Ausbildung einer ausreichenden Stabilität bzw. Steifigkeit ist neben der Primärschicht 10 eine Sekundärschicht 20 vorgesehen. Hierbei ist es vorgesehen, dass das Material, aus dem die Primärschicht 10 und die Sekundärschicht 20 gefertigt sind, ein Elastizitätsmodul bzw. E-Modul aufweist, das größer ist als dasjenige des Materials, aus dem die Leiterbahnen gefertigt sind. Um einem bei Temperaturänderungen auftretenden und das Trägersubstrat 1 wölbenden Bi-MetallEffekt entgegenzuwirken, ist es weiterhin vorzugsweise vorgesehen, dass das Trägersubstrat 1 in thermischer Hinsicht spiegelsymmetrisch oder im Wesentlichen thermomechanisch spiegelsymmetrisch zu einer metallischen Zwischenschicht 15, die zwischen der Primärschicht 10 und der Sekundärschicht 20 angeordnet ist, auszugestalten.

Beispielsweise ist das Trägersubstrat 1 in Hinblick auf seine Schichtfolge, d. h. hinsichtlich Anzahl und Art der Schichten, in Hinblick auf die jeweiligen Schichtdicken und/oder in Hinblick auf die für die Schichten verwendeten Materialien spiegelsymmetrisch ausgestaltet oder die einzelnen Schichten sind diesbezüglich aneinander angepasst. Insbesondere ist die Sekundärschicht 20 aus einem Material gefertigt, dessen Ausdehnungskoeffizienten vorzugsweise demjenigen des Materials, aus dem die Primärschicht 10 gefertigt ist, entspricht. Dabei ist es erfindungsgemäß vorgesehen, dass die Sekundärschicht 20 aus Keramik, Molybdän, Wolfram oder Verbundwerkstoffen auf Basis WCu oder MoCu gefertigt ist. In dem dargestellten Ausführungsbeispiel ist die Sekundärschicht 20 aus Keramik gefertigt. Vorstellbar ist auch, dass die Ausdehnungskoeffizienten des Primärsubstrats 10' und des Sekundärsubstrats 20' innerhalb eines festgelegten Toleranzbereichs übereinstimmen. Vorzugsweise weichen die Ausdehnungskoeffizienten des Primärsubstrats 10' und des Sekundärsubstrats 20' weniger als +/- 20 %, bevorzugt weniger als +/- 10 % voneinander ab. Durch eine entsprechende Auswahl der Materialien in Hinblick auf die Ausdehnungskoeffizienten für das Primärsubstrat 10' und das Sekundärsubstrat 20' lässt sich durch die Ausgestaltung des Trägersubstrats 1 mit dem Primärsubstrat 10' und dem Sekundärsubstrat 20' nicht nur die Steifigkeit des Trägersubstrats 1 in vorteilhafter Weise vergrößern, sondern es wird darüber hinaus etwaigen thermischen Spannungen, die bei der Herstellung des Trägersubstrats 1 oder bei dessen bestimmungsgemäßen Betrieb auftreten, entgegengewirkt.

Um den Wärmetransport von der Bauteilseite 4 zur Kühlseite 5 zu verbessern, ist es weiterhin vorgesehen, dass zwischen der Primärschicht 10 und der Sekundärschicht 20 eine mehrlagige oder eine einlagige metallische Zwischenschicht 15 angeordnet ist. Dabei ist die metallische Zwischenschicht 15 dicker als die Primärschicht 10 und/oder die Sekundärschicht 20, insbesondere dicker als eine Summe aus der Primärschichtdicke und der Sekundärschichtdicke. Vorzugsweise ist die Zwischenschicht 15 größer als das Doppelte, bevorzugt größer als das Dreifache oder besonders bevorzugt größer als das Fünffache der aufsummierten Schichtdicke aus der Primärschicht 10 und der Sekundärschicht 20. Dadurch bildet sich in Gestalt der Zwischenschicht 15 eine thermische Masse aus.

Die Anordnung der als thermische Masse fungierenden metallischen Zwischenschicht 15 zwischen der Primärschicht 10 und der Sekundärschicht 20 erweist sich insofern als vorteilhaft, als dass die Zwischenschicht 15 als Zwischenspeicher dient, der sich im Besonderen in Einschalt- und/oder Überlastsituationen als besonders vorteilhaft erweist. Dadurch können höhere kurzfristige Spitzenleistungen über die Wärmekapazität von der Zwischenschicht 15 abgefangen werden und im Falle eines Ausfalls des an die Kühlseite angebundenen Wärmetauschers bzw. der Wärmesenke wird die Zeitspanne vergrößert, in der auf den Ausfall reagiert werden kann, ohne dass bleibende Schäden an dem Trägersubstrat 1 zurückbleiben. Weiterhin sorgt die Sekundärschicht 20 für eine ausreichende Stabilität, die es erlaubt, die Schichtdicke der Primärschicht 10 zu reduzieren. Das wirkt sich auf Grund der unmittelbaren Nähe der Primärschicht 10 zu den wärmegebenden Bauteilen 13 auf dem Trägersubstrat 1 besonders vorteilhaft auf den thermischen Widerstand aus. Außerdem verteilt sich die von den lokalen Wärmequellen auf der Bauteilseite 4 ausgehende Wärme großflächiger in der Zwischenschicht 15, da die Dicke der Zwischenschicht 15 ein ausreichendes Aufspreizen bzw. ungerichtetes Ausbreiten der Wärme über eine vergleichsweise große Distanz zulässt, was sich ebenfalls vorteilhaft auf den thermischen Widerstand auswirkt. Ferner erweist sich die vergleichsweise große Dicke der Zwischenschicht 15 insofern als vorteilhaft, als dass sie die Steifigkeit des Trägersubstrats 1 weiter erhöht und so einem Durchbiegen, veranlasst durch unterschiedliche Ausdehnungskoeffizienten sowie äußere Spannungen und Kräfte wie sie beispielsweise vom Druck der Kühlflüssigkeit auf das Substrat verursacht werden, entgegenwirkt.

Zur Reduktion von im Betrieb an dem Trägersubstrat 1 auftretenden parasitären Induktionseffekten ist es ferner vorzugsweise vorgesehen, dass die metallische Zwischenschicht 15 als weitere Leiterbahn verwendet wird. Dabei ist eine Durchkontaktierung 11, d. h. ein Via, in der Primärschicht 10 vorgesehen, über die die metallische Zwischenschicht 15 mit einem Strom beaufschlagt werden kann oder über die ein elektrisch leitende Verbindung zwischen der metallischen Zwischenschicht 10 und einem metallischen Anschlusselement auf der Primärschicht 10 realisiert ist. Um eine ausreichende elektrische Isolation sicherzustellen, ist bei Trägersubstraten 1 mit einer Durchkontaktierung 11 die Sekundärschicht 20 insbesondere eine elektrisch isolierende Schicht, beispielsweise eine weitere Keramikschicht. In der in Figur 1 dargestellten Ausführungsform sind auf der Bauteilseite, d. h. auf der Primärschicht angebrachte Kontaktelemente vorgesehen, über die die metallischen Zwischenschicht 15 mit einer Spannung beaufschlagt werden kann.

In der dargestellten Ausführungsform ist es vorgesehen, dass die Zwischenschichtdicke b zwischen 1,1- und 10- mal, bevorzugt zwischen 1,2 und 5 mal, besonders bevorzugt zwischen 1,3 und 3 mal oder sogar im Wesentlichen 1,5 mal so dick ist wie die Primärschichtdicke $a^1$ und/oder die Sekundärschichtdicke $a^2$. Beispielsweise nimmt die Zwischenschichtdicke b einen Wert zwischen 1 mm und 10 mm, bevorzugt zwischen 1 mm und 5 mm, besonders bevorzugt zwischen 1,5 mm und 5 mm oder sogar einen Wert von im Wesentlichen 1,5 mm an. Weitere davon abweichende, insbesondere größere, Zwischenschichtdicken sind ebenfalls möglich.

Alternativ ist es vorgesehen, dass die Zwischenschichtdicke b zwischen 2,5- und 100- mal, bevorzugt zwischen 3,5 und 50 mal, besonders bevorzugt zwischen 10 und 25 mal oder sogar im Wesentlichen 2,0 mal so dick ist wie die Primärschichtdicke $a^1$ und/oder die Sekundärschichtdicke $a^2$. Beispielsweise nimmt die Zwischenschichtdicke b einen Wert zwischen 1 mm und 10 mm, bevorzugt zwischen 1 mm und 5 mm, besonders bevorzugt zwischen 1,5 mm und 5 mm oder sogar einen Wert von im Wesentlichen 3 mm an.

Weiterhin ist es bevorzugt vorgesehen, dass die Primärschichtdicke $a^1$ der Sekundärschichtdicke $a^2$ im Wesentlichen entspricht. Alternativ ist es vorstellbar, dass die Sekundärschichtdicke $a^2$ im Wesentlichen 1,5 mal bis 5 mal, bevorzugt 1,3 mal bis 2,5 mal und besonders bevorzugt 1,1 bis 2 mal so dick ist wie die Primärschichtdicke $a^1$. Weiterhin können die Dickenverhältnisse so strukturiert sein, dass $a^2 = 0{,}5 - 2{,}0\ a^1$, bevorzugt $a^2 = 0{,}7 - 1{,}6\ a^1$, besonders bevorzugt $a^2 = 0{,}8 - 1{,}2\ a^1$ ist.

Mit anderen Worten: die Dickenverhältnisse können so strukturiert sein, dass $a^2 = 0{,}5\ a^1$ bis $2{,}0\ a^1$, bevorzugt $a^2 = 0{,}7\ a^1$ bis $1{,}6\ a^1$, besonders bevorzugt $a^2 = 0{,}8\ a^1$ bis $1{,}2\ a^1$ ist.

Weiterhin ist es vorgesehen, dass die Kühlstruktur 30 einen Basiskörperbereich B1 und einen Stegbereich S1 aufweist. Der Stegbereich S1 wird vorzugsweise durch senkrecht vom Basiskörperbereich B1 abstehende Stege bzw. Finnen gebildet, während der Basiskörperbereich B1 insbesondere einen massiven Bereich bzw. unstrukturierten Körper bildet. Vorzugsweise sind der Basiskörperbereich B1 und der Stegbereich S1 einstückig ausgebildet. Dabei nimmt ein Verhältnis zwischen einer Stegbereichsdicke SD zu einer Basiskörperdicke BD einen Wert zwischen 1,2 bis 6, bevorzugt zwischen 1,4 und 3 und besonders bevorzugt zwischen 1,6 und 2,5 annimmt. Weiterhin ist es vorgesehen, dass eine Kühlstrukturdicke KD, insbesondere eine effektive Kühlstrukturdicke d30.E 0,03 bis 1 mal, bevorzugt 0,1 bis 0,5 und besonders bevorzugt 0,15 bis 0,3 so groß ist wie die Zwischenschichtdicke b.

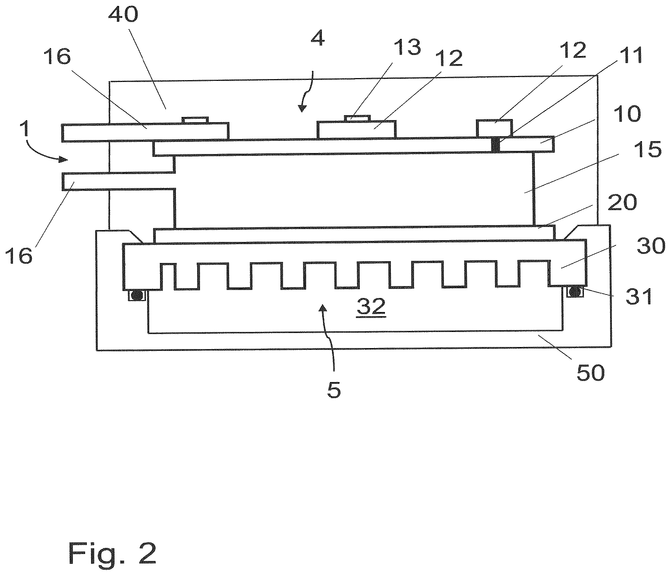

In der **Figur 2** ist schematisch ein Trägersubstrat 1 für elektrische Bauteile 13 gemäß einer zweiten beispielhaften Ausführungsform der vorliegenden Erfindung in einer Schnittansicht dargestellt. Dabei stimmt das Trägersubstrat 1 im Wesentlichen mit dem aus der Figur 1 überein. Im Gegensatz zu der Ausführungsform aus Figur 1 ist hierbei ein Kontaktelement 16 an der Zwischenschicht 15 vorgesehen. Dieses Kontaktelement 16 erlaubt eine direkte Kontaktierung des Zwischenelements 15, um dieses zur Reduktion von parasitären induktiven Effekten am Trägersubstrat 1 mit einer Spannung zu beaufschlagen und so einen Strom in der Zwischenschicht 15 zu veranlassen. Ferner ist es vorgesehen, dass das Trägersubstrat 1 von einem Gehäuseteil 40 auf der Bauteilseite 4 umgeben ist. Insbesondere handelt es sich hierbei um ein gegossenes Gehäuseteil 40. Um die Leiterbahnen 12 auf der Primärschicht 10 zu kontaktieren, ist ebenfalls ein Kontaktelement 16 vorgesehen. Um die Leiterbahn 12 auf der Primärschicht 10 und die Zwischenschicht 15 mit einer Spannung zu beaufschlagen, ist es vorgesehen, dass die Kontaktelemente 16 der Zwischenschicht 15 und der Oberseite der Primärschicht 10 durch das Gehäuseteil 40 geführt werden. Hierbei ragen die Kontaktelemente 16 vorzugsweise auf derselben Seite einer Gehäuseteilwandung aus dem Gehäuseteils 40 heraus.

In der dargestellten Ausführungsform umfasst das Trägersubstrat 1 zur Bildung eines Fluidkanals 32, in dem im Betrieb beispielsweise eine Kühlflüssigkeit entlang einer Strömungsrichtung transportiert wird, ein Schalenelement 50, insbesondere ein kunststoffhaltiges Schalenelement 50, auf, das vorzugsweise mit der Kühlstruktur 30 verclipst ist. Zur Abdichtung der Verbindung zwischen Kühlstruktur 30 und Schalenelement 50 ist ein Dichtelement 31 vorgesehen, das in einer entsprechenden Aussparung im Schalenelement 50 eingelassen ist. Die auf der Kühlseite 5 des Trägersubstrats 1 angeordneten Nadeln bzw. Pins der Kühlstruktur 30 ragen dabei in dem im Betrieb mit der Kühlflüssigkeit gefüllten Fluidkanal 32 hinein.

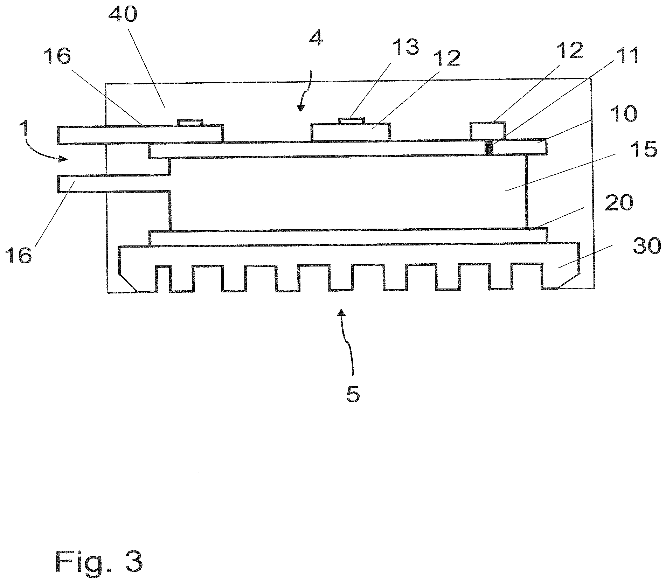

In der **Figur 3** ist schematisch ein Trägersubstrat 1 für elektrische Bauteile 13 gemäß einer dritten beispielhaften Ausführungsform der vorliegenden Erfindung in einer Schnittansicht dargestellt. Hierbei stimmt das Trägersubstrat 1 im Wesentlichen mit dem aus der Figur 2 überein. Neben den Merkmalen des Trägersubstrats 1 aus der Figur 2 ist es hier vorgesehen, dass das gegossene Gehäuseteil 40 zur Kühlseite 5 mit der Kühlstruktur 30 bündig abschließt. Dies gestattet es in vorteilhafter Weise, das Trägersubstrat 1 einfach auf eine Kühlstruktur, beispielsweise auf ein Schalenelement 50 draufzusetzten oder zu befestigen. Dadurch lässt sich das Trägersubstrat 1 besonders flexibel einsetzen. Hierzu ist es insbesondere vorgesehen, dass die Kühlstruktur 30 in einem oder mehreren Randbereichen eine Hinterschneidung oder einen Rücksprung aufweist, damit die Kühlstruktur 30 entlang einer senkrecht zur Primärschicht 10 verlaufenden Richtung formschlüssig mit dem Gehäuseteil 40 zusammenwirkt.

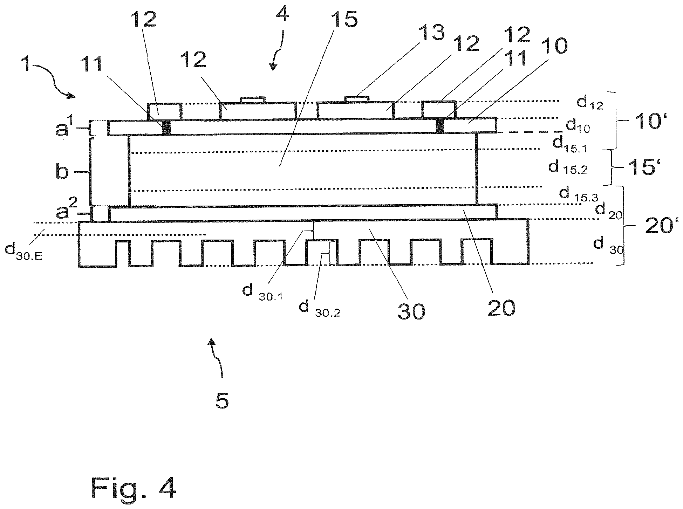

In **Figur 4** ist ein Trägersubstrat für elektrische Bauteile gemäß einer vierten beispielhaften Ausführungsform der vorliegenden Erfindung dargestellt. Zur Dimensionierung der Primärschicht, der Sekundärschicht und der metallischen Zwischenschicht ist es hierbei vorgesehen, dass das Trägersubstrat 1 virtuell in ein Primärsubstrat 10', ein Sekundärsubstrat 20 und vorzugsweise in eine dazwischen befindliche virtuelle Zwischenschicht 15' zerlegt wird. Das Primärsubstrat 10' wird aus den Schichten d12, d10 und d15.1 und das Sekundärsubstrat aus den Schichten d15.3, d20 und d30 gebildet. Bei der Dimensionierung wird eine thermomechanische Symmetrie zwischen dem Primärsubstrat und dem Sekundärsubstrat angestrebt, d.h. der thermische Ausdehnungskoeffizient (CTE) des Primärsubstrats 10' und des Sekundärsubstrats 20' soll vorzugsweise gleich oder zumindest ähnlich sein, beispielsweise innerhalb einer Toleranz von +/- 20 oder bevorzugt von +/- 10 % übereinstimmen. Dies ist erforderlich, um mögliche thermomechanische Spannungen und die daraus resultierenden Durchbiegungseffekte zu reduzieren. Der resultierende Wärmeausdehnungskoeffizient CTE' eines geschichteten Verbundmaterials wird näherungsweise wie folgt errechnet:

$$CTE' = \frac{\sum_{i=1}^{n} CTEi\ Ei\ di}{\sum_{i=1}^{n} Ei\ di}$$

Hierbei wird angenommen, dass sich das jeweilige Teilsubstrat nicht oder nur unwesentlich biegt. Diese mögliche Biegung wird vermieden, indem die beidseitigen Metallisierungen in thermomechanischer Hinsicht gleich bzw. ähnlich sind, das bedeutet, dass z.B. bei vollflächigen Metallisierungen beide Metallschichten gleich oder zumindest ähnlich dick sind. Daraus ergibt sich, das vorzugsweise d15.1 = d12 und d15.3 = d30E ist.

Für das Primärsubstrat gilt damit:

$$CTE10' = \frac{CTE12\ E12\ d12 + CTE10\ E10\ d10 + CTE15.1\ E15.1\ d15.1}{E12\ d12 + E10\ d10 + E15.1\ d15.1}$$

und das Sekundärsubstrat gilt:

$$CTE20' = \frac{CTE15.3\ E15.3\ d15.3 + CTE20\ E20\ d20 + CTE30\ E30\ d30E}{E15.3\ d15.3 + E20\ d20 + E30\ d30E}$$

Wobei d30E die thermomechanisch effektiv wirkende Dicke der Kühlstruktur 30 ist. Die Dicke d30Eist von der Strukturierung der Kühlstruktur 30 abhängig, für die folgendes gilt:

$$d30.1 \leq d30E \leq d30$$

Ist es bei der Dimensionierung der einzelnen Komponenten bzw. Schichten des Trägersubstrates 1 nicht sinnvoll möglich eine vollständige thermomechanische Symmetrie (CTE10' = CTE20') einzustellen, ist eine temperaturabhängige Biegung zu erwarten. Der beschriebene Ansatz dient primär der Optimierung des Schichtaufbaus in thermomechanischer Hinsicht mit dem Ziel möglichst ebene Trägersubstrate 1 zu realisieren.

Die Wahl der Zwischenschicht 15 und damit die Dicke d15.2 der resultierenden virtuellen Zwischenschicht, d.h. des Zwischensubstrats 15', ist von der notwendigen thermischen Masse abhängig, die das zeitlichen Verhalten des Trägersubstrates 1 maßgeblich definiert. Die für die thermische Masse relevanten Schichten bzw. Schichtdicken sind die der Leiterbahn d12, der Zwischenschicht d15 sowie die Basisdicke d30.1 der Kühlstruktur 30. Die Dicke der thermischen Pufferlagen ist somit mit *dCu_th* = d12 + d15 + d30.1 definiert. Die Dicke der thermischen Pufferlagen *dCu_th* ist zwischen 1 und 10 mm, bevorzugt zwischen 1,1 und 5 mm, besonders bevorzugt zwischen 1,2 und 3 mm. Die optimale Biegung h ist in den meisten Anwendungsfällen null. Der Betrag der Biegung h ist kleiner als 200 $\mu$m, bevorzugt kleiner als 100 $\mu$m und besonders bevorzugt kleiner als 50$\mu$m. Alle oben gemachten Angaben sind näherungsweise zu verstehen, da die jeweilige Strukturierung insbesondere der Leiterbahnen d12 sowie der Kühlstruktur 30 sowie abweichend wirkende Randeffekte an den Kanten der Komponenten nicht pauschal Berücksichtigung finden können. Die o.g. Modelle basieren auf einem rein elastischen Verhalten der Materialien. Der Einfluss der plastischen Deformation spielt hier eine untergeordnete Rolle.

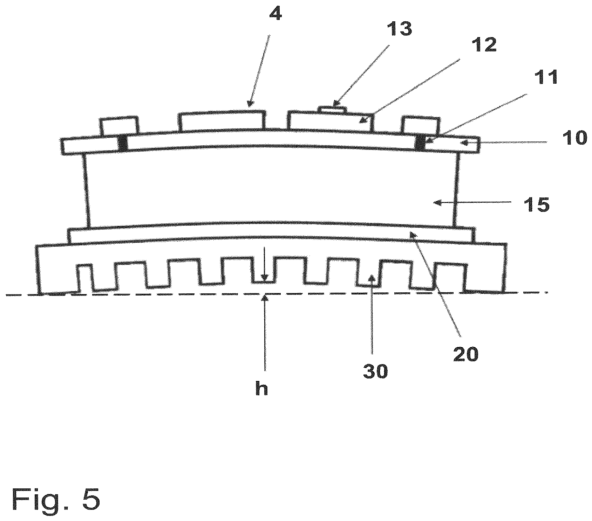

In der **Figur 5** ist das Trägersubstrat 1 für elektrische Bauteile 13 gemäß der vierten beispielhaften Ausführungsform der vorliegenden Erfindung dargestellt. Dabei ist das Trägersubstrat 1 in einem gebogenen Zustand dargestellt, in der das Trägersubstrat 1 eine Biegung h aufweist.

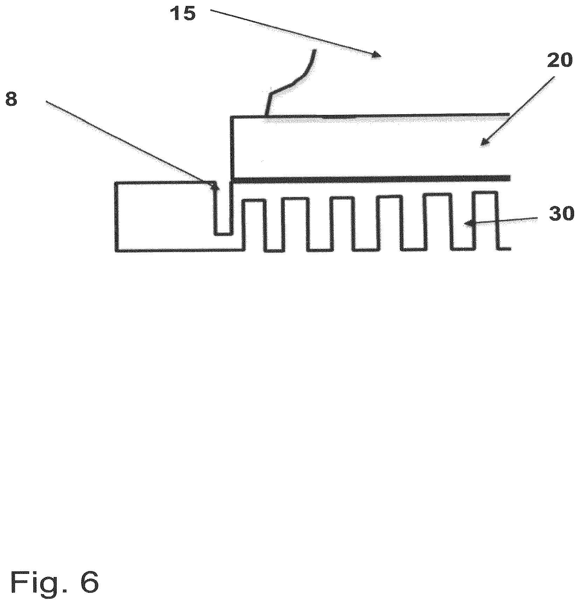

In der **Figur 6** ist eine Kühlstruktur 30 für ein Trägersubstrat 1 gemäß einer fünften Ausführungsform der vorliegenden Erfindung. Hierbei ist es vorgesehen, dass eine Ausnehmung 8 auf der der Sekundärschicht 20 und/oder der Primärschicht 10 zugewandten Seite der als Kühlstruktur 30 ausgestalteten Metallschicht angeordnet ist. Insbesondere ist es vorgesehen, dass die Ausnehmung 8 in einer parallel zur Haupterstreckungsebene verlaufenden Richtung gegenüber der Primärschicht 10 und/oder Sekundärschicht 20 versetzt angeordnet ist, wobei die Kühlstruktur 30 gegenüber der Primärschicht 10 und/oder der Sekundärschicht 20 vorsteht. Insbesondere ist es vorgesehen, dass die Ausnehmung als Dehnungsfuge ausgestaltet ist, um zu vermeiden, dass die thermische Ausdehnung der Kühlstruktur 30 mechanische Spannungen im gesamten Trägersubstrat 1 veranlasst. Der Schutzbereich des Patents wird durch die Patentansprüche bestimmt.

**Bezugszeichenliste**

| | |
|---|---|
| 1 | Trägersubstrat |
| 4 | Bauteilseite |
| 5 | Kühlseite |
| 8 | Ausnehmung |
| 10 | Primärschicht |
| 10' | Primärsubstrat |
| 11 | Durchkontaktierung |
| 12 | Leiterbahn |
| 13 | elektrisches Bauteil |
| 16 | Kontaktelement |
| 15 | Zwischenschicht |
| 15' | Zwischensubstrat |
| 20 | Sekundärschicht |
| 20' | Sekundärsubstrat |
| 30 | Kühlstruktur |
| 31 | Dichtelement |
| 32 | Fluidkanal |
| 40 | Gehäuseteil |
| 50 | Schalenelement |

| | |
|---|---|
| $a^1$ | Primärschichtdicke |
| $a^2$ | Sekundärschichtdicke |
| KD | Kühlstrukturdicke |
| BD | Basiskörperdicke |
| SD | Stegbereichdicke |
| b | Zwischenschichtdicke |
| h | Biegung |
| d12, d10 und d15.1 | Schichtdickenbeiträge zum Primärsubstrat |
| d15.3, d20 und d30 | Schichtdickenbeiträge zum Sekundärsubstrat |
| d15.2 | Schichtdicke des Zwischensubstrats |
| d30.E | effektive Schichtdicke der Kühlerstruktur |
| d30.1, d30.2 | Schichtdickenbeiträge zur Kühlstruktur |

**Patentansprüche**

1. Trägersubstrat (1) für elektrische Bauteile (13), wobei das Trägersubstrat (1) eine Bauteilseite (4) mit Leiterbahnen (12) und eine der Bauteilseite (4) gegenüberliegende Kühlseite (5) mit einer Kühlstruktur (30) aufweist, wobei das Trägersubstrat (1) zur elektrischen Isolation eine der Bauteilseite (4) zugewandte und aus Keramik gefertigte Primärschicht (10) und zur Versteifung des Trägersubstrats (1) eine der Kühlseite (5) zugewandte Sekundärschicht (20) umfasst, wobei zur Wärmeübertragung von der Bauteilseite (4) zur Kühlseite (5) zwischen der Primärschicht (10) und der Sekundärschicht (20) eine metallische Zwischenschicht (15) angeordnet ist, wobei die metallische Zwischenschicht (15) dicker als die Primärschicht (10) und die Sekundärschicht (20) ist, wobei die Sekundärschicht (20) aus Molybdän, Wolfram oder einem Verbundwerkstoff, der auf WCu oder MoCu basiert, gefertigt ist.

2. Trägersubstrat (1) gemäß Anspruch 1, wobei die Zwischenschicht (15) zwischen 2,5- und 100- mal, bevorzugt zwischen 3,5 und 50 mal, besonders bevorzugt zwischen 10 und 25 mal oder sogar im Wesentlichen 20 mal so dick ist wie die Primärschicht und/oder die Sekundärschicht.

3. Trägersubstrat (1) gemäß einem der vorhergehenden Ansprüche, wobei die Zwischenschicht (15) zwischen 1 mm und 10 mm, bevorzugt zwischen 1 mm und 5 mm, besonders bevorzugt zwischen 1.2mm und 3 mm oder sogar im Wesentlichen 3 mm dick ist.

4. Trägersubstrat (1) gemäß einem der vorhergehenden Ansprüche, wobei die Zwischenschicht (15) dicker als 1,4 mm und bevorzugt dicker als 1,9 mm ist.

5. Trägersubstrat (1) gemäß einem der vorhergehenden Ansprüche, wobei die Kühlstruktur (30) einen Basiskörperbereich (B1) und einen Stegbereich (S1) aufweist, wobei ein Verhältnis (SD / BD) zwischen einer Stegbereichsdicke (SD) zu einer Basiskörperdicke (BD) einen Wert zwischen 1,2 bis 6, bevorzugt zwischen 1,4 und 3 und besonders bevorzugt zwischen 1,6 und 2,5 annimmt.

6. Trägersubstrat (1) gemäß einem der vorhergehenden Ansprüche, wobei die effektive Kühlstrukturdicke (d30.E) 0,15 bis 0,3 mal so groß ist wie die metallische Zwischenschichtdicke (15).

7. Trägersubstrat (1) gemäß einem der vorhergehenden Ansprüche, wobei die metallische Zwischenschicht (15) einlagig ausgestaltet ist.

8. Trägersubstrat (1) gemäß einem der vorhergehenden Ansprüche, wobei ein Primärsubstrat (10') und ein Sekundärsubstratschicht (20') zur Vermeidung eines Durchbiegens des Trägersubstrats (1) in Hinblick auf ihre thermischen Ausdehnungen, insbesondere in Hinblick auf ihre Ausdehnungskoeffizienten, aneinander angepasst sind.

9. Trägersubstrat (1) gemäß einem der vorhergehenden Ansprüche, wobei als Abschluss des Trägersubstrats (1) auf der Kühlseite (5) an die Sekundärschicht (20) eine für eine Fluidkühlung vorgesehene Kühlstruktur (30), insbesondere eine Rippen-, Nadel- und/oder Noppenstruktur, unmittelbar angrenzt, wobei die Kühlstruktur (30) zum Korrosionsschutz vorzugsweise mit einer Korrosionsschutzschicht beschichtet ist.

10. Trägersubstrat (1) gemäß einem der vorhergehenden Ansprüche, wobei die Primärschicht (10) eine Durchkontaktierung (11) aufweist und/oder zur Bildung einer weiteren Leiterbahn die Zwischenschicht (15) ein Kontaktelement (16) aufweist.

11. Trägersubstrat (1) gemäß einem der vorhergehenden Ansprüche, wobei die Zwischenschicht (15) dicker ist als 1 mm.

12. Trägersubstrat (1) gemäß einem der vorhergehenden Ansprüche, wobei die metallische Zwischenschicht (15), die Leitungsbahn (12), das Kontaktelement (16), das metallische Anschlusselement (13) und/oder die Kühlstruktur (30) zur Erhöhung der Temperaturwechselbeständigkeit auf der der Primärschicht oder der der Sekundärschicht zugewandten Seite eingeätzte Strukturen aufweist.

13. Trägersubstrat (1) gemäß einem der vorhergehenden Ansprüche, wobei das Trägersubstrat (1) ein die Bauteilseite (4) ummantelndes Gehäuseteil (40), insbesondere ein als Gussteil ausgestaltetes Gehäuseteil (40), aufweist, wobei das Gehäuseteil (40) vorzugsweise mit der auf der Kühlseite (5) angeordneten Kühlstruktur (30) bündig abschließt.

14. Verfahren zur Herstellung eines Trägersubstrats (1) gemäß einem der vorhergehenden Ansprüche.

15. Verfahren gemäß Anspruch 14, wobei die thermischen Ausdehnungskoeffizienten des Primärsubstrats (10') und des Sekundärsubstrats (20') aneinander angepasst werden.

**Claims**

1. A carrier substrate (1) for electrical components (13), wherein the carrier substrate (1) has a component side (4) having conductor tracks (12) and a cooling side (5) opposite the component side (4) having a cooling structure (30), wherein the carrier substrate (1) comprises a primary layer (10) facing the component side (4) and made of ceramics for electrical insulation and a secondary layer (20) facing the cooling side (5) for stiffening the carrier substrate (1), wherein, for the heat transfer from the component side (4) to the cooling side (5), a metal intermediate layer (15) is arranged between the primary layer (10) and the secondary layer (20), wherein the metal intermediate layer (15) is thicker than the primary layer (10) and the secondary layer (20), wherein the secondary layer (20) is made of molybdenum, tungsten or a composite material based on WCu or MoCu.

2. The carrier substrate (1) according to claim 1, wherein the intermediate layer (15) is between 2.5 and 100 times, preferably between 3.5 and 50 times, especially preferably between 10 and 25 times or even substantially 20 times the thickness of the primary layer and/or the secondary layer.

3. The carrier substrate (1) according to one of the preceding claims, wherein the intermediate layer (15) is between 1 mm and 10 mm, preferably between 1 mm and 5 mm, especially preferably between 1.2 mm and 3 mm or even substantially 3 mm thick.

4. The carrier substrate (1) according to one of the preceding claims, wherein the intermediate layer (15) is thicker than 1.4 mm and preferably thicker than 1.9 mm.

5. The carrier substrate (1) according to one of the preceding claims, wherein the cooling structure (30) comprises a base body region (B1) and a web region (S1), wherein a ratio (SD / BD) between a web region thickness (SD) to a base body thickness (BD) assumes a value between 1.2 to 6, preferably between 1.4 and 3 and especially preferably between 1.6 and 2.5.

6. The carrier substrate (1) according to one of the preceding claims, wherein the effective cooling structure thickness (d30.E) is 0.15 to 0.3 times the metal intermediate layer thickness (15).

7. The carrier substrate (1) according to one of the preceding claims, wherein the metalintermediate layer (15) is configured as a single layer.

8. The carrier substrate (1) according to one of the preceding claims, wherein a primary substrate (10') and a secondary substrate layer (20') are adapted to each other with respect to the thermal expansions thereof, in particular with respect to the coefficients of expansion thereof, to prevent sagging of the carrier substrate (1).

9. The carrier substrate (1) according to one of the preceding claims, wherein a cooling structure (30) provided for fluid cooling, in particular a rib, needle and/or nub structure, is directly adjacent to the secondary layer (20) as a completion of the carrier substrate (1) on the cooling side (5), wherein the cooling structure (30) is preferably coated with an anti-corrosion layer for corrosion protection.

10. The carrier substrate (1) according to one of the preceding claims, wherein the primary layer (10) has a through-plating (11) and/or the intermediate layer (15) has a contact element (16) to form an additional conductor track.

11. The carrier substrate (1) according to one of the preceding claims, wherein the intermediate layer (15) is thicker than 1 mm.

12. The carrier substrate (1) according to one of the preceding claims, wherein the metal intermediate layer (15), the conductive track (12), the contact element (16), the metal interface element (13) and/or the cooling structure (30) have etching structures on the side facing the primary layer or the side facing the secondary layer to increase thermal shock resistance.

13. The carrier substrate (1) according to one of the preceding claims, wherein the carrier substrate (1) has a housing part (40) encasing the component side (4), in particular a housing part (40) designed as a casting part, wherein the housing part (40) is preferably flush with the cooling structure (30) arranged on the cooling side (5).

14. A method for manufacturing a carrier substrate (1) according to one of the preceding claims.

15. The method according to claim 14, wherein the thermal expansion coefficients of the primary substrate (10') and the secondary substrate (20') are adapted to each other.

**Revendications**

1. Substrat porteur (1) pour des composants électriques (13), le substrat porteur (1) présentant un côté composant (4), muni de pistes conductrices (12), et un côté refroidissement (5) opposé au côté composant (4) et muni d'une structure de refroidissement (30), le substrat porteur (1) comprenant, pour l'isolation électrique, une couche primaire (10) tournée vers le côté composant (4) et fabriquée en céramique et, pour la rigidification du substrat porteur (1), une couche secondaire (20) tournée vers le côté refroidissement (5),

    une couche intermédiaire métallique (15) étant disposée entre la couche primaire (10) et la couche secondaire (20) pour le transfert de chaleur du côté composant (4) au côté refroidissement (5), la couche intermédiaire métallique (15) étant plus épaisse que la couche primaire (10) et la couche secondaire (20), la couche secondaire (20) étant réalisée en molybdène, en tungstène ou en un matériau composite à base de WCu ou de MOCu.

2. Substrat porteur (1) selon la revendication 1, dans lequel la couche intermédiaire (15) est entre 2,5 et 100 fois, de préférence entre 3,5 et 50 fois, de manière particulièrement préférée entre 10 et 25 fois, ou même sensiblement 20 fois plus épaisse que la couche primaire et/ou la couche secondaire.

3. Substrat porteur (1) selon l'une des revendications précédentes, dans lequel la couche intermédiaire (15) a une épaisseur comprise entre 1 mm et 10 mm, de préférence entre 1 mm et 5 mm, de manière particulièrement préférée entre 1,2 mm et 3 mm, ou même sensiblement égale à 3 mm.

4. Substrat porteur (1) selon l'une des revendications précédentes, dans lequel la couche intermédiaire (15) a une épaisseur supérieure à 1,4 mm et de préférence supérieure à 1,9 mm.

5. Substrat porteur (1) selon l'une des revendications précédentes, dans lequel la structure de refroidissement (30) présente une zone de corps de base (B1) et une zone d'arête (S1), un rapport (SD/BD) entre une épaisseur de zone d'arête (SD) et une épaisseur de corps de base (BD) prenant une valeur comprise entre 1,2 et 6, de préférence entre 1,4 et 3, et de manière particulièrement préférée entre 1,6 et 2,5.

6. Substrat porteur (1) selon l'une des revendications précédentes, dans lequel l'épaisseur de structure de refroidissement (d30.E) effective est de 0,15 à 0,3 fois plus grande que l'épaisseur de couche intermédiaire (15) métallique.

**7.** Substrat porteur (1) selon l'une des revendications précédentes,
dans lequel la couche intermédiaire métallique (15) est réalisée en une seule couche.

**8.** Substrat porteur (1) selon l'une des revendications précédentes,
dans lequel un substrat primaire (10') et une couche de substrat secondaire (20') sont adaptés l'un à l'autre quant à leurs dilatations thermiques, en particulier quant à leurs coefficients de dilatation, pour éviter un fléchissement du substrat porteur (1).

**9.** Substrat porteur (1) selon l'une des revendications précédentes,
dans lequel, en tant que terminaison du substrat porteur (1) sur le côté refroidissement (5), une structure de refroidissement (30), en particulier une structure à nervures, à aiguilles et/ou à picots, prévue pour un refroidissement par fluide, est directement adjacente à la couche secondaire (20), la structure de refroidissement (30) étant de préférence revêtue d'une couche de protection anti-corrosion pour la protection contre la corrosion.

**10.** Substrat porteur (1) selon l'une des revendications précédentes,
dans lequel la couche primaire (10) présente un via (11) et/ou, pour former une autre piste conductrice, la couche intermédiaire (15) présente un élément de contact (16).

**11.** Substrat porteur (1) selon l'une des revendications précédentes,
dans lequel la couche intermédiaire (15) présente une épaisseur supérieure à 1 mm.

**12.** Substrat porteur (1) selon l'une des revendications précédentes,
dans lequel la couche intermédiaire métallique (15), la piste conductrice (12), l'élément de contact (16), l'élément de connexion (13) métallique et/ou la structure de refroidissement (30) présente(nt) des structures gravées sur la face tournée vers la couche primaire ou vers la couche secondaire, afin d'augmenter la résistance aux chocs thermiques.

**13.** Substrat porteur (1) selon l'une des revendications précédentes,
dans lequel le substrat porteur (1) présente une partie de boîtier (40) enveloppant le côté composant (4), en particulier une partie de boîtier (40) réalisée sous forme de pièce coulée, la partie de boîtier (40) se terminant de préférence en affleurement avec la structure de refroidissement (30) disposée sur le côté refroidissement (5).

**14.** Procédé de fabrication d'un substrat porteur (1) selon l'une des revendications précédentes.

**15.** Procédé selon la revendication 14,
dans lequel les coefficients de dilatation thermique du substrat primaire (10') et du substrat secondaire (20') sont adaptés l'un à l'autre.

Fig. 1

Fig. 2

Fig. 3

Fig. 4

Fig. 5

15

8

20

30

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004033933 A1
- DE 102009022877 A1
- EP 2892074 A1
- US 2010065962 A1
- WO 2016121660 A1
- US 3744120 A
- DE 2319854 C2